# EUROPEAN PATENT SPECIFICATION

(11) **EP 3 467 159 B1**
(45) Date of publication and mention of the grant of the patent: **11.01.2023**
(21) Application number: 18197096.3
(22) Date of filing: 27.09.2018
(51) Int. Cl.: C30B 29/16, C30B 33/06

(54) **SUBSTRATE MANUFACTURING METHOD**
SUBSTRATHERSTELLUNGSVERFAHREN
PROCÉDÉ DE FABRICATION DE SUBSTRATS

(30) Priority: 06.10.2017 JP 2017196005
(43) Date of publication of application: 10.04.2019
(73) Proprietor: Shin-Etsu Polymer Co., Ltd., Chiyoda-ku Tokyo 101-0041 (JP); Shin-Etsu Chemical Co., Ltd., Tokyo 100-0004 (JP); National University Corporation Saitama University, Saitama City, Saitama 338-8570 (JP)
(72) Inventor: IKENO, Junichi, Sakura-ku, Saitama-shi, Saitama 338-8570 (JP); YAMADA, Yohei, Sakura-ku, Saitama-shi, Saitama 338--8570 (JP); SUZUKI, Hideki, Kita-ku, Saitama-shi, Saitama 331-0811 (JP); NOGUCHI, Hitoshi, Chiyoda-ku, Tokyo 100-0004 (JP)
(74) Representative: SSM Sandmair

(56) References cited:
- EP-A1- 3 396 031
- WO-A1-2016/059449
- JP-A- 2015 119 076

## Description

### CROSS REFERENCE TO RELATED APPLICATION

This application claims priority of Japanese patent application No. 2017-196005 filed October 6, 2017, entitled "Substrate Manufacturing Method".

### TECHNICAL FIELD

The present disclosure relates to a substrate manufacturing method optimum for manufacturing a thin magnesium oxide single crystal substrate.

### BACKGROUND ART

A magnesium oxide single crystal substrate is used in the field of semiconductor, the field of display, the field of energy, and the like. In order to manufacture this magnesium oxide single crystal substrate, epitaxially growing this magnesium oxide single crystal substrate into a thin film shape is known as well as crystal-growing the magnesium oxide single crystal substrate into a bulk form and cutting the same into a substrate form (for example, refer to JP 2001-080996 A).

Meanwhile, it is thought that diamond is a semiconductor suitable for a highfrequency/high-output electronic device, and in vapor-phase synthesis as one of synthesis methods thereof, a magnesium oxide substrate or a silicon substrate is used as a base substrate (for example, refer to JP 2015-59069 A).

EP 3 396 031 A1 which claims priority of 26 April 2017 and was published on 31 October 2018 and is, thus, prior art in view of Article 54(3) EPC, discloses a substrate manufacturing method including: a first step of disposing a condenser for condensing a laser beam in a non-contact manner on a surface 20r of a magnesium oxide single crystal substrate to be irradiated; and a second step of irradiating a laser beam to a surface of the magnesium oxide single crystal substrate and condensing the laser beam into an inner portion of the single crystal member under designated irradiation conditions using the condenser, and at a same time, two-dimensionally moving the condenser and the magnesium oxide single crystal substrate relatively to each other, and sequentially forming processing marks to sequentially allow planar peeling.

JP 2015 119076 A discloses a substrate manufacturing method. By moving a single crystal member and laser condensing means relatively, while irradiating the irradiated surface of a silicon single crystal member with laser light B of continuous wave via the laser condensing means for condensing laser light, an internal processing layer formation single crystal member has a processed layer formed in the single crystal member, and a non-processed layer adjacent to both sides of the processed layer. In the processed layer 21, affected zones formed in the scanning direction of the laser light B are arranged so that the distance of adjacent affected zones has a predetermined value or less.

### SUMMARY

### TECHNICAL PROBLEM

In recent years, as performance of a semiconductor device has been enhanced, a magnesium oxide single crystal substrate, which is thin and has less lattice defects, has been being required more and more.

A magnesium oxide substrate (MgO substrate) that is a base substrate in manufacture of the above diamond substrate is expensive, and for example, the magnesium oxide substrate is peeled off and separated while keeping a thickness thereof necessary as a base substrate after subjecting single crystal diamond to gas-phase synthesis, whereby the magnesium oxide substrate becomes reusable as the base substrate. Specifically, for example, if a magnesium oxide substrate with a thickness of 180 µm is obtained and reused from a base substrate of magnesium oxide with a thickness of 200 µm, then it can be expected that significant cost reduction can be achieved in a manufacturing process of the diamond substrate, and that this achievement greatly contributes to cost reduction of the diamond substrate.

In view of the above problem, it is an object of the present disclosure to provide a substrate manufacturing method capable of easily obtaining the thin magnesium oxide single crystal substrate.

### SOLUTION TO PROBLEM

Incidentally, while a variety of manufacturing methods for obtaining a single crystal silicon substrate have been proposed, the inventors of the present disclosure found a manufacturing method, which is targeted for the magnesium oxide substrate andbased on a new processing principle different from that of single crystal silicon, in the present disclosure as a result of earnest study.

In accordance with an aspect of the present disclosure for solving the above problem, there is provided a substrate manufacturing method including: a first step of disposing a laser condensing means on a surface of a single crystal member of magnesium oxide to be irradiated in a non-contact manner, the laser condensing means being for condensing a laser beam, the laser beam having a power density of 1000 W/cm² or more; and a second step of irradiating the laser beam to a surface of the single crystal member and condensing the laser beam into an inner portion of the single crystal member under a designated irradiation condition using the laser condensing means, simultaneously moving the laser condensing means and the single crystal member two-dimensionally (XY plane) relative to each other, and forming processing mark lines in parallel to one another, each of the processing mark lines being composed by forming processing marks in a line at the inner portion of the single crystal member, the processing marks being formed by thermal processing, wherein, in the second step, continuously formed line portions in which the processing marks are continuously formed in at least a part of the processing mark lines such that air gaps that continue with one another are formed over the processing mark lines in the overlapped line portions, and planar peeling is caused from the irradiated surface side.

### EFFECTS

In accordance with the present disclosure, the substrate manufacturing method capable of easily obtaining the thin magnesium oxide single crystal substrate can be provided.

### BRIEF DESCRIPTION OF DRAWINGS

FIG. 1A is a schematic perspective view of a peeled substrate manufacturing apparatus for use in an embodiment of the present disclosure, and FIG. 1B is a partially enlarged side view of the peeled substrate manufacturing apparatus for use in the embodiment of the present disclosure.
FIG. 2 is a schematic side cross-sectional view explaining that a peeled substrate is peeled off from a magnesium oxide single crystal substrate in the embodiment of the present disclosure.
FIG. 3 is a schematic view explaining that processing marks are being formed in the embodiment of the present disclosure.
FIG. 4 is an explanatory view showing laser beam irradiation conditions and irradiation results in Example 1.
FIG. 5 is an explanatory view showing laser beam irradiation conditions and irradiation results in Example 2.
FIG. 6 is an explanatory view showing laser beam irradiation conditions and irradiation results in Example 2.
FIG. 7 is an explanatory view showing laser beam irradiation conditions and irradiation results in Example 2.
FIG. 8 is an explanatory view showing laser beam irradiation conditions and irradiation results in Example 2.
FIG. 9 is an explanatory view showing laser beam irradiation conditions and irradiation results in Example 2.
FIG. 10 is an explanatory view showing laser beam irradiation conditions and irradiation results in Example 2.
FIG. 11 is an explanatory view showing laser beam irradiation conditions and irradiation results in Example 2.

### DESCRIPTION OF EMBODIMENTS

Hereinafter, a description will be given of an embodiment of the present disclosure with reference to the accompanying drawings. In the following description, the same or similar reference numerals are assigned to the same constituents as or similar constituents to those already described, and a detailed description thereof is omitted as appropriate. Moreover, the embodiment shown below is an exemplification for embodying the technical idea of this disclosure, and the embodiment of this disclosure does not specify materials, shapes, structures, dispositions and the like of constituent components to those described below. The embodiment of this disclosure can be implemented while being changed in various ways within the scope of the claims.

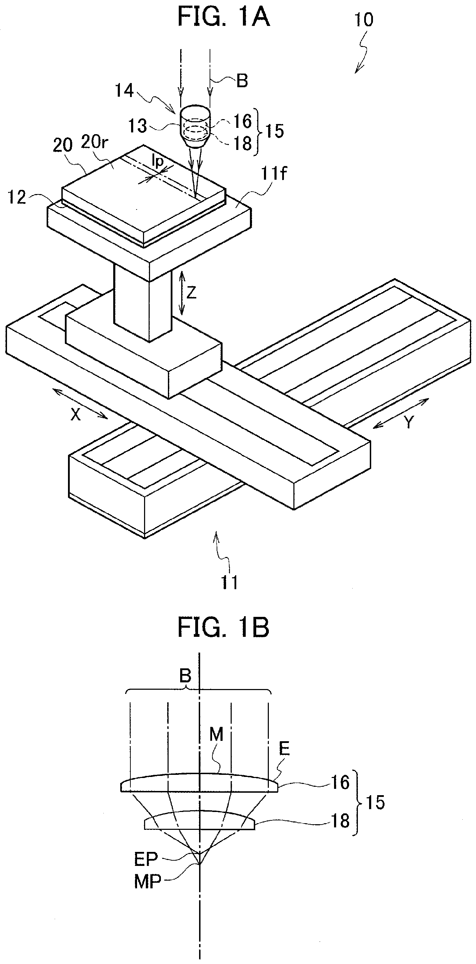

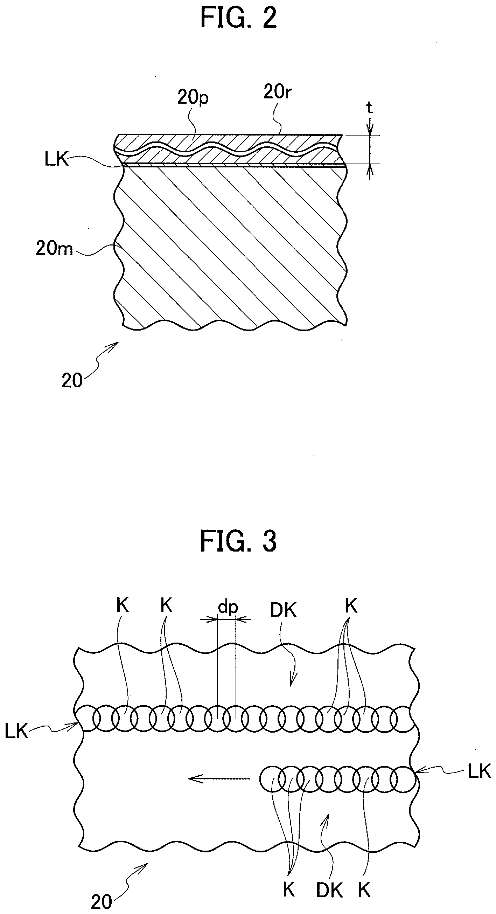

FIG. 1A is a schematic perspective view of a peeled substrate manufacturing apparatus for use in an embodiment of the present disclosure (hereinafter, the embodiment will be referred to as "this embodiment"), and FIG. 1B is a partially enlarged side view of the peeled substrate manufacturing apparatus for use in this embodiment. FIG. 2 is a schematic side cross-sectional view explaining that a peeled substrate is peeled off from a magnesium oxide single crystal substrate in this embodiment. FIG. 3 is an explanatory view explaining that processing marks are formed in this embodiment.

In this embodiment, a peeled substrate is obtained from a magnesium oxide single crystal substrate (MgO substrate) using a peeled substrate manufacturing apparatus 10 (refer to FIG. 1A).

The peeled substrate manufacturing apparatus 10 includes: an XY stage 11; a substrate mounting member 12 (for example, a silicon substrate) held on a stage surface 11f of the XY stage 11; and a laser condensing means 14 (for example, a condenser) for condensing a laser beam B toward a magnesium oxide single crystal substrate 20 mounted on the substrate mounting member 12. Note that, in FIG. 1A, the magnesium oxide single crystal substrate 20 is drawn into a rectangular shape when viewed from above; however, may have a wafer shape as a matter of course, and a shape of the magnesium oxide single crystal substrate 20 can be selected freely.

The XY stage 11 is configured to be capable of adjusting a height position (Z-axis direction position) of the stage surface 11f, in which a distance L between the stage surface 11f and the laser condensing means 14 is made adjustable, that is, a distance between the single crystal substrate on the stage surface 11f and the laser condensing means 14 is made adjustable. The XY stage 11 is also configured to be capable of adjusting positions in the XY plane.

In this embodiment, the laser condensing means 14 includes: a correction ring 13; and a condenser lens 15 held in the correction ring 13. The laser condensing means 14 has a function to correct an aberration caused by a refractive index of the single crystal substrate 20 made of magnesium oxide, that is, a function as an aberration correction ring. Specifically, as shown in FIG. 1B, when condensing the laser beam B in the air, the condenser lens 15 corrects the laser beam B so that such a laser beam B that has reached an outer peripheral portion E of the condenser lens 15 is condensed closer to the condenser lens 15 than such a laser beam B that has reached a center portion M of the condenser lens 15 is. That is, in the case of the beam condensation, the laser beam B is corrected so that a condensing point EP of the laser beam B that has reached the outer peripheral portion E of the condenser lens 15 is located at a position closer to the condenser lens 15 than a condensing point MP of the laser beam B that has reached the center portion M of the condenser lens 15 is.

This condenser lens 15 is composed of: a first lens 16 that condenses the laser beam B in the air; and a second lens 18 disposed between this first lens 16 and the single crystal substrate 20. In this embodiment, each of the first lens 16 and the second lens 18 is defined as a lens capable of condensing the laser beam B in a conical shape. Then, a rotational position of the correction ring 13 is adjusted, that is, an interval between the first lens 16 and the second lens 18 is adjusted, whereby it is made possible to adjust an interval between the condensing point EP and the condensing point MP The laser condensing means 14 has a function as a correction ring-attached lens.

As the first lens 16, besides a spherical or aspherical single lens, a set lens is usable for the purpose of a variety of aberration corrections and of ensuring a working distance.

### SUBSTRATE MANUFACTURING METHOD

Hereinafter, a description will be given of an example of manufacturing the magnesium oxide single crystal substrate that is thin from the magnesium oxide single crystal substrate with reference to the accompanying drawings.

In this embodiment, performed is a first step of disposing the laser condensing means 14 in a non-contact manner on an irradiated surface 20r of the magnesium oxide single crystal substrate 20 with less lattice defects (hereinafter, simply referred to as a single crystal substrate 20). Note that, though not shown, in the case of peeling off the magnesium oxide substrate while leaving such a thin substrate of the magnesium oxide substrate in the diamond substrate formed using the magnesium oxide substrate as a base substrate, the laser may be irradiated from the magnesium oxide substrate side.

After the first step, a second step is performed. In this second step, the laser beam B is irradiated to the surface of the single crystal substrate 20 and the laser beam B is condensed into an inner portion of the single crystal substrate 20 under designated irradiation conditions using the laser condensing means 14. Simultaneously with the irradiation and the condensation, the laser condensing means 14 and the single crystal substrate 20 are two-dimensionally moved relatively to each other. In this way, processing mark lines LK, each of which is composed in such a manner that processing marks K formed by thermal processing are formed in line at an inner portion of a single crystal member, are formed in parallel to one another (for example, refer to FIG. 3). At this time, overlapped line portions DK in which the processing marks K overlap one another are formed in at least a part of the processing mark lines LK, whereby planar peeling is caused from the irradiated surface 20r side.

Here, the processing marks in this description refer to ranges where the component of the single crystal substrate has scattered from condensed positions by the condensation of the laser beam. On a center portion of each of the ranges (that is, processing marks), a void-shaped air gap like a crater is formed. Moreover, in this description, the planar peeling is a concept including a state in which the peeled substrate will be peeled off by receiving slight force even if the peeled substrate is not actually peeled off.

In this second step, in consideration of a thickness of a peeled substrate 20p (refer to FIG. 2) manufactured by the planar peeling described above, a relative distance between the laser condensing means 14 and the single crystal substrate 20 is preset so that the laser beam B is focused at a designated height position, that is, so that the laser beam B is focused at a designated depth position from the irradiated surface 20r of the single crystal substrate 20.

Moreover, in this embodiment, in the case of overlapping the processing marks with one another, a scanning speed of the laser beam is adjusted so as to overlap the processing marks with one another on at least a part thereof in a scanning direction U of the laser beam B. Furthermore, a scanning direction is set along a crystal orientation of the single crystal substrate.

The processing marks K are sequentially formed, whereby the planar peeling occurs naturally, and the peeled substrate 20p is formed on the irradiated surface side. On a laser-condensed side of the peeled substrate, a mark trace seen as halves of the processing marks K formed by the condensation of the laser beam B is formed on such a laser-condensed side of the peeled substrate.

This mark trace is such a mark trace looking like a resultant of melting and solidifying a part of the magnesium oxide substrate. This resultant seems to be caused by generation of voids and scattering of the magnesium oxide substrate to peripheries of the voids due to eruption. Moreover, on the other peeled substrate, a mark trace seen as the other halves of the processing marks K is formed. This mark trace is such a mark trace looking like a resultant of melting and solidifying a part of the component of the magnesium oxide single crystal substrate. The following is estimated. That is, by the condensation of the laser beam B, such air gaps are formed between the substrate portions to be peeled off from each other, and these air gaps continue with one another, whereby the planar peeling occurs. Moreover, frequently, the voids are arrayed on one of the peeled surfaces subjected to the planar peeling.

The designated irradiation conditions of the laser beam B are preset so that the planar peeling occurs naturally as described above. In this setting of the designated irradiation conditions, in consideration of properties (crystal structure or the like) of the single crystal substrate 20, the thickness t of the peeled substrate 20p to be formed (refer to FIG. 2), an energy density of the laser beam B at a focal point, and the like, set are a variety of values such as a wavelength of the laser beam B to be irradiated, an aberration correction amount (defocus amount) of the condenser lens 15, a laser output, a dot pitch dp of the processing mark K (refer to FIG. 3; an interval between adjacent processing marks in the same processing mark line, that is, an interval between a processing mark and a processing mark formed immediately therebefore), and a line pitch lp (refer to FIG. 1A; an offset pitch: an interval between adjacent processing mark lines). The obtained peeled substrate 20p is thereafter subjected to post treatment such as polishing of the peeled surface according to needs.

In accordance with this embodiment, the thin magnesium oxide single crystal substrate can be obtained easily. Moreover, since the thin magnesium oxide single crystal substrate is obtained by being peeled from the single crystal substrate 20 with less lattice defects, the thin magnesium oxide single crystal substrate thus obtained has less lattice defects.

Moreover, in the case of at least partially overlapping the processing marks with one another, the processing marks are overlapped with one another on at least a part thereof in the scanning direction of the laser beam, and accordingly, the processing marks K thus overlapping one another can be formed efficiently. In addition, it is easy to uniform dimensions of the respective overlapping portions.

Note that, though FIG. 3 illustrates the example where all of the processing mark lines LK are composed of the overlapped line portions DK, the planar peeling may be caused from the irradiated surface 20r side by forming the overlapped line portions DK in a part of the processing mark lines LK. In this way, the time taken to form the processing mark lines LK can be shortened. Moreover, when all of the processing mark lines Lk are composed of the overlapped line portions DK, it is easy to cause the planar peeling over the entire surface of the irradiated region.

Moreover, the single crystal substrate 20 is used as the single crystal member of the magnesium oxide, and such peeled substrates 20p with the same dimension can be sequentially peeled, thus making it possible to sufficiently increase utilization efficiency of the magnesium oxide single crystal member (that is, to sufficiently suppress an occurrence of chips of the magnesium oxide).

Further, since the scanning direction of the laser beam is set along the crystal orientation of the single crystal substrate 20, it is easy to obtain the laser irradiation that naturally causes the planar peeling.

Moreover, in this embodiment, it is desirable to use a high intensity laser beam as the laser beam B. In the present disclosure the high intensity laser beam is specified by peak power (a value obtained by dividing pulse energy by a pulse width) and a power density (a value per unit area of energy per unit time). Generally, a high-output laser can be used in order to increase the power density. Meanwhile, in this embodiment, for example, when the laser beam B is irradiated by such a high output that exceeds 1 kW, such a substrate to be machined is damaged, and the thin processing marks taken as a target cannot be formed. That is, preferably, the high intensity laser beam for use in this embodiment is the laser beam B with a short pulse width and a low laser output, which does not damage the machined substrate.

A laser beam with a short pulse width (for example, a laser beam with a pulse width of 10 ns or less) is preferable in order to further increase the power density. The laser beam with a short pulse width is irradiated as described above, thus making it easy to remarkably increase the power density of the high intensity laser beam.

Moreover, in this embodiment, it is possible to implement the aberration correction by the correction ring 13 and the condenser lens 15, which are owned by the laser condensing means 14, and in the second step, the defocus amount can be set by the aberration correction. In this way, a range of the designated irradiation conditions described above can be greatly widened. When it is possible to select means for adjusting a depth of forming the processing marks and conditions for thinly forming the processing marks depending on a thickness of the substrate to be machined and a thickness of such a substrate to be peeled off, and the thickness of the magnesium oxide substrate to be machined is 200 to 300 µm, then the above range can be widened effectively by setting the defocus amount to 30 to 120 µm.

Moreover, in the case of taking out the peeled substrate 20p subjected to the planar peeling from the single crystal substrate 20, an abutment member to be brought into surface contact with the peeled substrate 20p may be brought into surface contact with the peeled substrate 20p and may be taken out. In this way, this abutment member is used as a member to which it is desired that the peeled substrate 20p be pasted, thus making it possible to shorten a pasting step. Moreover, when an end edge of the peeled substrate 20p is not completely peeled off from the single crystal substrate 20, then it is also made possible to peel off the peeled substrate 20p from the end edge and take out the peeled substrate 20p while suppressing the peeled substrate 20p from being broken. Moreover, from a viewpoint of facilitating natural peeling even if nothing is done after the irradiation of the laser beam, it is preferable to establish a state in which peeling strength at this time is 2 MPa or less, and further, falls down below 1.0 MPa.

Moreover, the above embodiment has been described by the example of holding the substrate mounting member 12 on the XY stage 11, mounting the single crystal substrate 20 on the substrate mounting member 12, and irradiating the laser beam B to the single crystal substrate 20. However, it is also possible to directly mount and hold the single crystal substrate 20 on the XY stage 11, and to form the processing marks K by the laser beam B.

Further, this embodiment has been described by the example of obtaining the peeled substrate 20p from the single crystal substrate 20 (magnesium oxide single crystal substrate); however, the material of the peeled substrate 20p is not limited to the single crystal single crystal substrate 20, and the irradiated surface 20r may be subjected to the planar peeling from a single crystal member of magnesium oxide, and the peeled substrate 20p may be obtained.

### EXAMPLE 1

The inventors of the present disclosure used the peeled substrate manufacturing apparatus 10 described in the above embodiment, held a silicon wafer as the substrate mounting member 12 on the stage surface 11f of the XY stage 11, and mounted and held a magnesium oxide single crystal substrate 20u (an MgO single crystal substrate; hereinafter, simply referred to as a single crystal substrate 20u occasionally) as the single crystal substrate 20 on this silicon substrate. In this example, as the magnesium oxide single crystal substrate 20u to be irradiated with the laser beam, a substrate with a crystal orientation of (100), a thickness of 300 µm and a diameter of 50.8 mmcp was used.

Then, by the substrate manufacturing method described in the above embodiment, in order to sequentially form the processing marks K at an inner portion of each of irradiation experiment regions of the single crystal substrate 20u, the laser beam B was irradiated to each irradiation experiment region of the single crystal substrate 20u from the irradiated surface thereof, and at the same time, the laser condensing means 14 and the single crystal substrate 20u were two-dimensionally (in a plane form) moved relatively to each other.

In this example, the laser beam B was irradiated in a line form (linearly), whereby one processing mark line LK (refer to FIG. 3) was formed, another processing mark line LK was formed in parallel to this processing mark line LK at a position apart therefrom at a designated amount of offset interval, and still another processing mark line was further formed in a similar way at a position apart therefrom at the designated amount of offset interval.

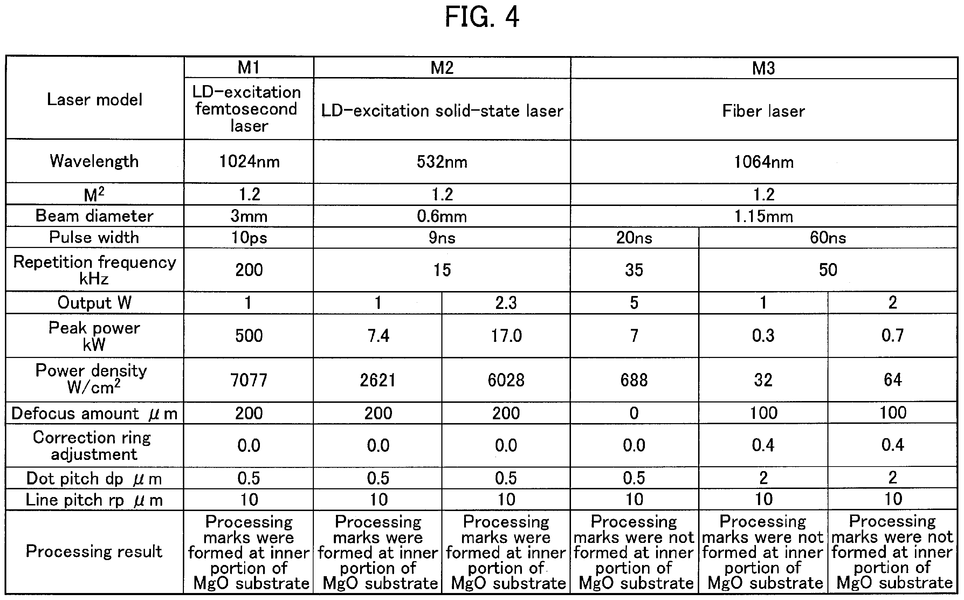

Then, in this example, irradiation tests of the laser beam were carried out individually for the cases of setting the wavelength of the laser beam B to 1024 nm (laser model M1 (LD-excitation femtosecond laser; pulse width: 10 ps)), 532 nm (laser model M2 (LD-excitation solid-state laser; pulse width: 9 ns)), and 1064 nm (laser model M3 (fiber laser; pulse width: 20 ns, 60 ns). Irradiation conditions and irradiation results are shown in FIG. 4.

In this example, after the laser beam was irradiated, influences from the peak power and power density of the laser beam B in the formation of the processing marks were evaluated.

In the laser models M1 and M2, conditions enabling the processing marks K to be formed at the inner portion of the single crystal substrate were found; however, in the laser model M3 (fiber laser), the processing marks K were not able to be formed by the irradiation of the laser beam B to the inner portion of the single crystal substrate. The reason for this is believed to be due to lack of the peak power and the power density.

The power densities in the laser models M2 and M3 when the peak powers thereof are 7.4 kW and 7 kW which are approximate to each other are greatly different from each other. Such a great difference is believed to affect whether it is possible to form the processing marks. That is, factors enabling the formation of the marking marks also include a beam diameter, the pulse width, a repetition frequency, and the like, and among them, the shorter pulse width is effective.

Preferably, the laser beam for use in the present disclosure is a high-luminance laser as described above, and preferably, the peak power of the laser beam is 10 kW or more. In the present invention the power density obtained from the peak power is 1000 W/cm² or more. Moreover, the shorter pulse width is effective in order to increase the power density, and the pulse with is preferably 10 ns or less, more preferably 100 ps or less. The pulse width is still more preferably 15 ps or less.

### EXAMPLE 2

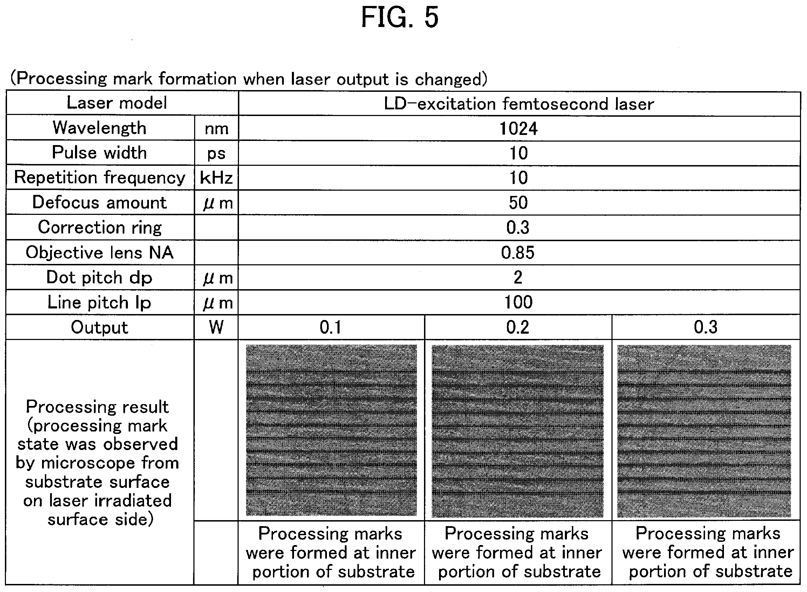

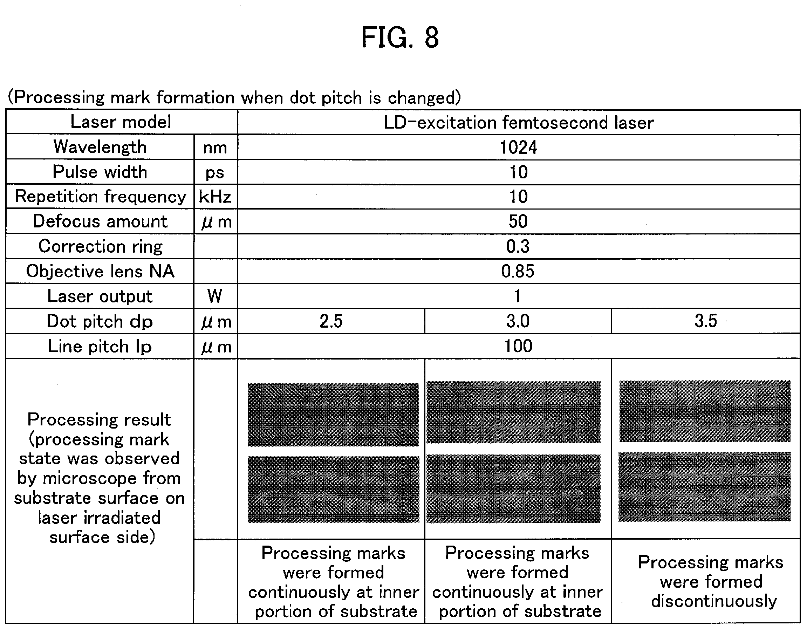

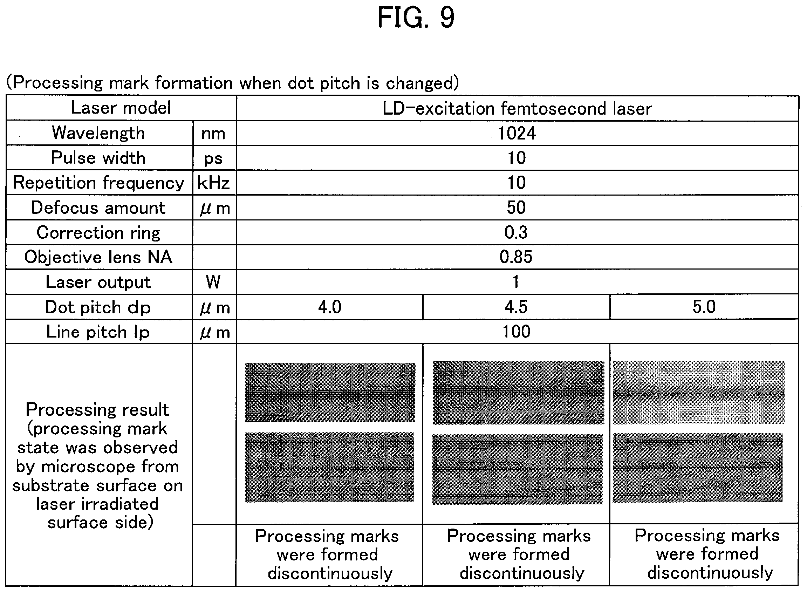

Moreover, the inventors of the present disclosure used the peeled substrate manufacturing apparatus 10 in a similar way to Example 1, set the wavelength of the laser beam B to 1024 nm, that is, used the laser model M1 (LD-excitation femtosecond laser), carried out an irradiation test while individually changing the laser output, the dot pitch dp and the line pitch lp as parameters, and evaluated relationships thereamong. Irradiation conditions and irradiation results are shown in FIG. 5 to FIG. 11.

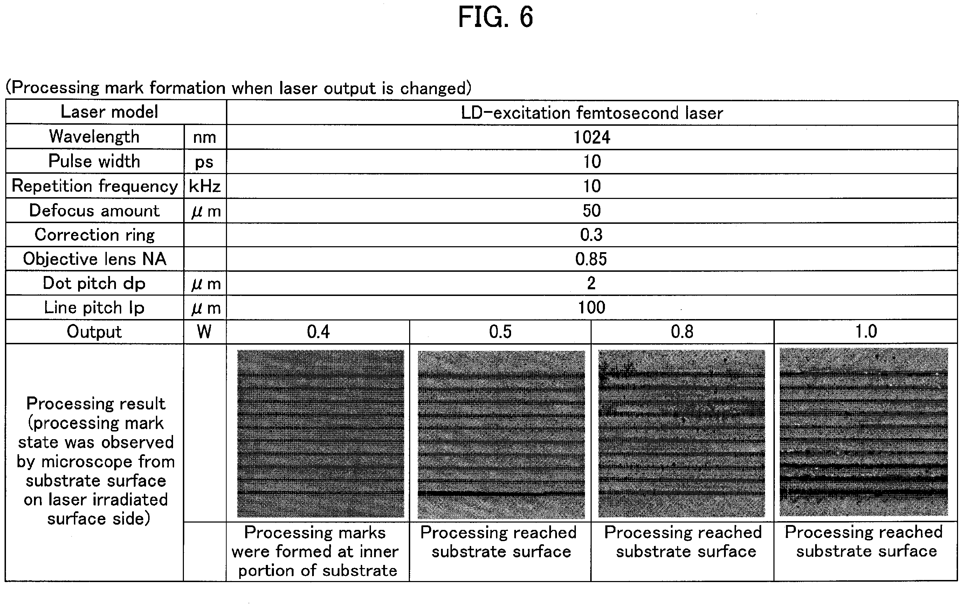

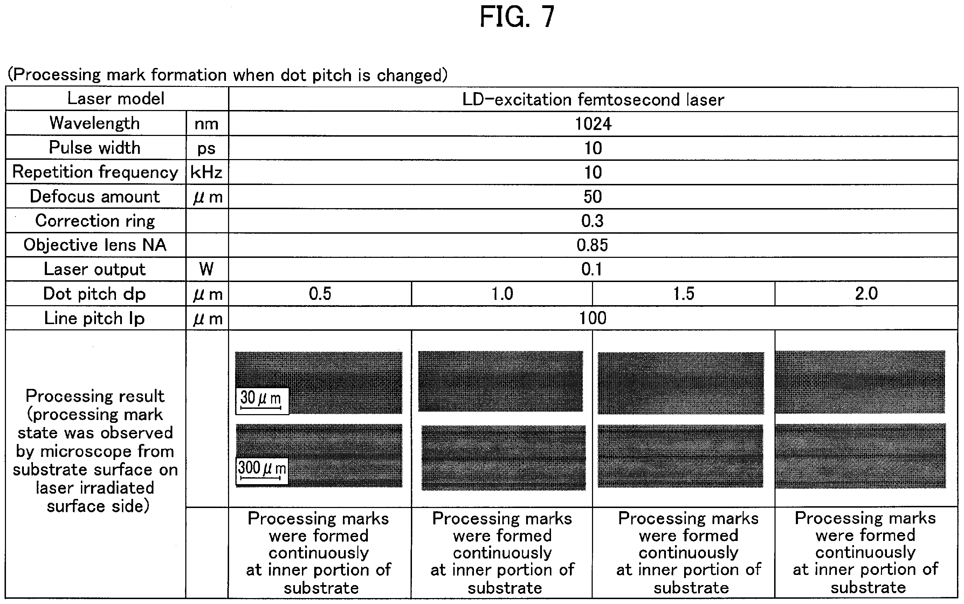

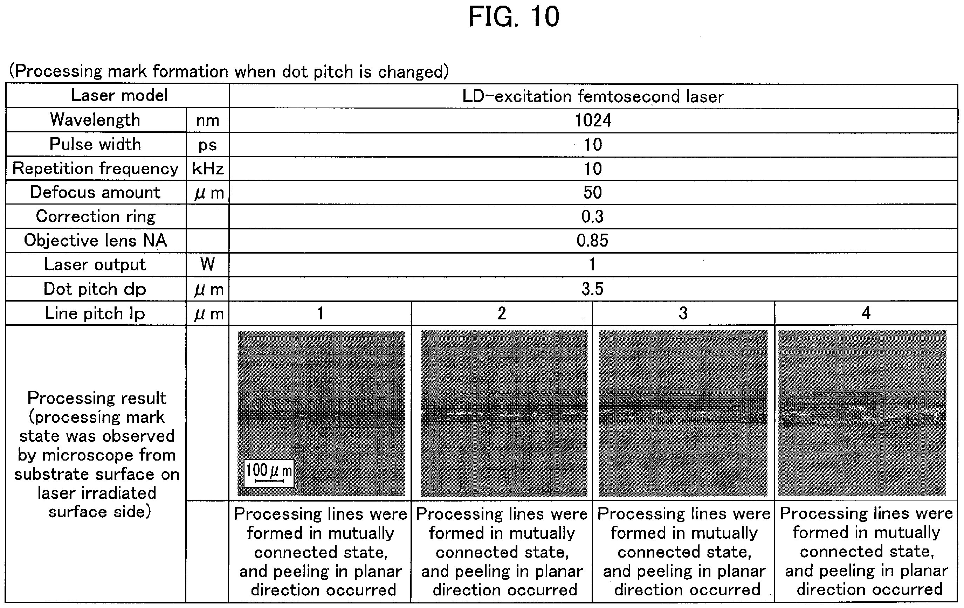

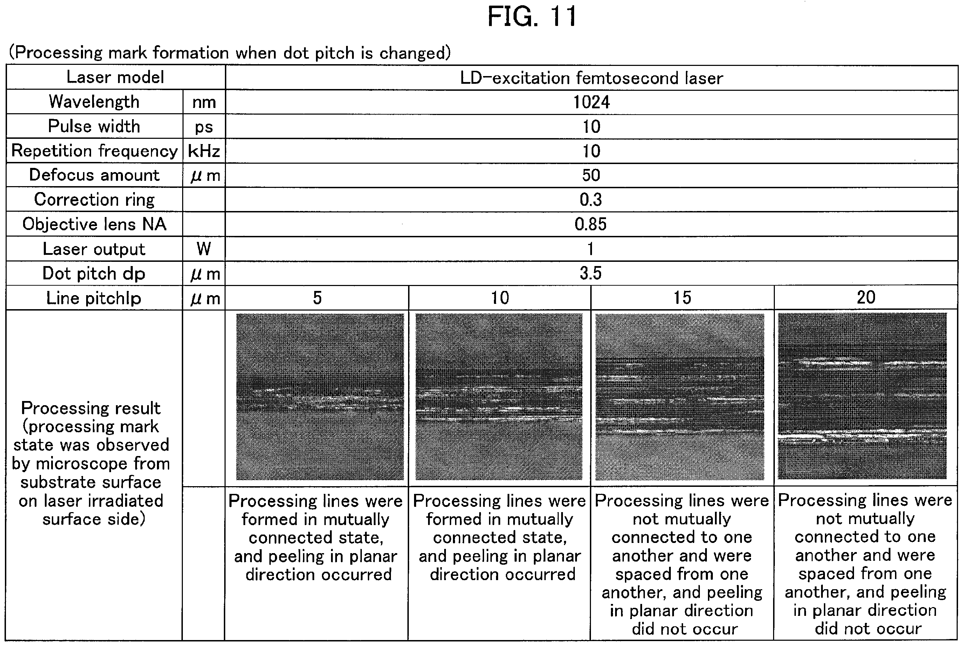

As shown in FIG. 5 and FIG. 6, the output of 0.4 W or less resulted in that the surface of the substrate was not machined. Moreover, as shown in FIG. 7 to FIG. 9, the dot pitch of 3.0 µm or less resulted in that the processing marks were formed in a continuous state. Moreover, as shown in FIG. 10 and FIG. 11, the line pitch of 10 µm or less resulted in that processing lines connected to one another to cause the peeling in the planar direction, that is, the processing marks connected to one another to cause the planar peeling.

In this example, in order to facilitate the peeling after the irradiation of the laser beam, the processing marks formed by thermal processing by the condensation of the laser beam at the inner portion of the single crystal member are formed in a state of being laminated on one another at least partially. Here, the processing marks can look like being molten and solidified. In this example, it was found that it was possible to evaluate this state by microscopic evaluation from the laser irradiation surface, that is, it was possible to determine that such a state was caused by the continuous formation of the processing marks. Then, this example provided knowledge that it was possible to appropriately select the laser output, the dot pitch dp and the line pitch lp.

### INDUSTRIAL APPLICABILITY

The magnesium oxide single crystal substrate peeled by the present disclosure can be formed efficiently, and accordingly, the peeled substrate obtained from the magnesium oxide single crystal substrate is useful for a high-temperature superconductive film, a ferroelectric film and the like, and is applicable to the field of semiconductor, the field of display, the field of energy, and the like.

### LIST OF REFERENCE SYMBOLS

- 10: peeled substrate manufacturing apparatus
- 11: XY stage
- 11f: stage surface
- 12: substrate mounting member
- 13: correction ring
- 14: laser condensing means
- 15: condenser lens
- 16: first lens
- 18: second lens
- 20: magnesium oxide single crystal substrate (single crystal member)
- 20p: peeled substrate
- 20r: irradiated surface
- 20u: magnesium oxide single crystal substrate (single crystal member)
- B: laser beam
- E: outer peripheral portion
- EP: condensing point
- K: processing mark
- LK: processing mark line
- M: center portion
- MP: condensing point
- M1: laser model
- M2: laser model
- M3: laser model
- dp: dot pitch
- lp: line pitch

## Claims

1. A substrate manufacturing method, comprising:
a first step of disposing a laser condensing means on a surface of a single crystal member of magnesium oxide to be irradiated in a non-contact manner, the laser condensing means being for condensing a laser beam, the laser beam having a power density of 1000 W/cm² or more; and
a second step of irradiating the laser beam to a surface of the single crystal member and condensing the laser beam into an inner portion of the single crystal member under a designated irradiation condition using the laser condensing means, simultaneously moving the laser condensing means and the single crystal member two-dimensionally relative to each other, and forming processing mark lines in parallel with one another, each of the processing mark lines being composed by forming processing marks in a line at the inner portion of the single crystal member, the processing marks being formed by thermal processing,
wherein, in the second step, continuously formed line portions in which the processing marks are continuously formed in at least a part of the processing mark lines, such that air gaps that continue with one another are formed over the processing mark lines in the overlapped line portions, and planar peeling is caused from the irradiated surface side.

2. The substrate manufacturing method according to claim 1, wherein the continuously formed line portions are formed over an entirety of the processing mark lines.

3. The substrate manufacturing method according to claim 1, wherein a single crystal substrate is used as the single crystal member.

4. The substrate manufacturing method according to claim 1, wherein when continuously forming the processing marks at least partially, the processing marks are continuously formed at least partially in a scanning direction of the laser beam.

5. The substrate manufacturing method according to claim 4, wherein the scanning direction is set along a crystal orientation (100) of the single crystal member.

6. The substrate manufacturing method according to claim 1, wherein the laser beam has a peak power of 10 kW or more.

7. The substrate manufacturing method according to claim 6, wherein a laser beam with a pulse width of 10 ns or less is irradiated as the laser beam.

8. The substrate manufacturing method according to claim 7, wherein a laser beam with a pulse width of 100 ps or less is irradiated as the laser beam.

9. The substrate manufacturing method according to claim 8, wherein a laser beam with a pulse width of 15 ps or less is irradiated as the laser beam.

## Patentansprüche

1. Substratherstellungsverfahren, das aufweist:
einen ersten Schritt zum Anodnen eines Laser-Kondensierungsmittels auf einer Oberfläche von einem Einkristallbereich aus Magnesiumoxid, um in einer kontaktlosen Weise bestrahlt zu werden, wobei das Laser-Kondensierungsmittel zum Kondensieren eines Laserstrahles ist, wobei der Laserstrahl eine Leistungsdichte von 1000 W/cm² oder mehr hat; und
einen zweiten Schritt zum Bestrahlen mit dem Laserstrahl auf eine Oberfläche von dem Einkristallbereich und Kondensieren des Laserstrahls in einen inneren Abschnitt von dem Einkristallbereich unter einer bestimmten Bestrahlungsbedingung, wobei das Laser-Kondensierungsmittel verwendet wird, wobei gleichzeitig das Laserkondensierungsmittel und der Einkristallbereich zweidimensional relativ zueinander bewegt werden, und es werden Bearbeitungsmarkierungslinien parallel zueinander ausgebildet, wobei jede der Bearbeitungsmarkierungslinien durch Ausbilden von Bearbeitungsmarkierungen in einer Linie an dem inneren Abschnitt von dem Einkristallbereich gebildet wird, wobei die Bearbeitungsmarkierungen durch thermische Bearbeitung ausgebildet werden,
wobei in dem zweiten Schritt kontinuierlich ausgebildete Linienabschnitte, in welchen die Bearbeitungsmarkierungen kontinuierlich zumindest in einem Teil der Bearbeitungsmarkierungslinien ausgebildet werden, so dass die Luftlücken, die miteinander fortgesetzt werden, über die Bearbeitungsmarkierungslinien in den überlappenden Linienabschnitten ausgebildet werden, und planares Peeling wird von der bestrahlten Oberflächenseite veranlasst.

2. Substratherstellungsverfahren gemäß Anspruch 1, wobei die kontinuierlich ausgebildeten Linienabschnitte über die Gesamtheit der Bearbeitungsmarkierungslinien ausgebildet werden.

3. Substratherstellungsverfahren gemäß Anspruch 1, wobei ein Einkristallsubstrat als der Einkristallbereich verwendet wird.

4. Substratherstellungsverfahren gemäß Anspruch 1, wobei, wenn die Bearbeitungsmarkierungen zumindest teilweise kontinuierlich ausgebildet werden, die Bearbeitungsmarkierungen zumindest teilweise in einer Abtastrichtung von dem Laserstrahl kontinuierlich ausgebildet werden.

5. Substratherstellungsverfahren gemäß Anspruch 4, wobei die Abtastrichtung entlang einer Kristallorientierung (100) von dem Einkristallbereich eingestellt wird.

6. Substratherstellungsverfahren gemäß Anspruch 5, wobei der Laserstrahl eine Spitzenleistung von 10 kW oder mehr hat.

7. Substratherstellungsverfahren gemäß Anspruch 6, wobei ein Lasserstrahl mit einer Pulsbreite von 10 ns oder weniger als der Laserstrahl ausgestrahlt wird.

8. Substratherstellungsverfahren gemäß Anspruch 7, wobei ein Laserstrahl mit einer Pulsbreite von 100 ps oder weniger als der Laserstrahl abgestrahlt wird.

9. Substratherstellungsverfahren gemäß Anspruch 8, wobei ein Laserstrahl mit einer Pulsbreite von 15 ps oder weniger als der Laserstrahl abgestrahlt wird.

## Revendications

1. Procédé de fabrication de substrat, comprenant :
une première étape consistant à disposer un moyen de condensation laser sur une surface d'un élément monocristallin d'oxyde de magnésium devant être irradié de manière sans contact, le moyen de condensation laser étant destiné à condenser un faisceau laser, le faisceau laser ayant une densité de puissance de 1000 W/cm² ou plus ; et
une deuxième étape consistant à irradier le faisceau laser sur une surface de l'élément monocristallin et condenser le faisceau laser dans une partie interne de l'élément monocristallin dans une condition d'irradiation désignée en utilisant le moyen de condensation laser, en déplaçant simultanément le moyen de condensation laser et l'élément monocristallin de manière bidimensionnelle l'un par rapport à l'autre, et formant des lignes de marque de traitement en parallèle les unes avec les autres, chacune des lignes de marque de traitement étant composée en formant des marques de traitement sur une ligne au niveau de la partie interne de l'élément monocristallin, les marques de traitement étant formées par traitement thermique,
dans lequel, dans la deuxième étape, des parties de ligne formées en continu dans lesquelles les marques de traitement sont formées en continu dans au moins une partie des lignes de marque de traitement, de telle sorte que des espaces d'air qui se poursuivent les uns avec les autres sont formés sur les lignes de marque de traitement dans les parties de ligne superposées, et un pelage planaire est provoqué depuis le côté de la surface irradiée.

2. Procédé de fabrication de substrat selon la revendication 1, dans lequel les parties de ligne formées en continu sont formées sur la totalité des lignes de marque de traitement.

3. Procédé de fabrication de substrat selon la revendication 1, dans lequel un substrat monocristallin est utilisé en tant qu'élément monocristallin.

4. Procédé de fabrication de substrat selon la revendication 1, dans lequel lors de la formation continue des marques de traitement au moins partiellement, les marques de traitement sont formées en continu au moins partiellement dans une direction de balayage du faisceau laser.

5. Procédé de fabrication de substrat selon la revendication 4, dans lequel la direction de balayage est établie le long d'une orientation cristalline (100) de l'élément monocristallin.

6. Procédé de fabrication de substrat selon la revendication 1, dans lequel le faisceau laser a une puissance de crête de 10 kW ou plus.

7. Procédé de fabrication de substrat selon la revendication 6, dans lequel un faisceau laser avec une largeur d'impulsion de 10 ns ou moins est irradié en tant que faisceau laser.

8. Procédé de fabrication de substrat selon la revendication 7, dans lequel un faisceau laser avec une largeur d'impulsion de 100 ps ou moins est irradié en tant que faisceau laser.

9. Procédé de fabrication de substrat selon la revendication 8, dans lequel un faisceau laser avec une largeur d'impulsion de 15 ps ou moins est irradié en tant que faisceau laser.
